Europäisches Patentamt

European Patent Office

Office européen des brevets

(19)

(11) Veröffentlichungsnummer : **0 513 033 B1**

(12)

# EUROPÄISCHE PATENTSCHRIFT

(45) Veröffentlichungstag der Patentschrift :
**17.11.94 Patentblatt 94/46**

(51) Int. Cl.$^5$ : **H03M 1/66, H03M 1/06**

(21) Anmeldenummer : **91902177.4**

(22) Anmeldetag : **19.01.91**

(86) Internationale Anmeldenummer :
**PCT/EP91/00101**

(87) Internationale Veröffentlichungsnummer :
**WO 91/11862 08.08.91 Gazette 91/18**

(54) **VERFAHREN UND ANORDNUNG ZUR UMWANDLUNG VON DIGITALEN SIGNALEN IN ANALOGE SIGNALE.**

(30) Priorität : **29.01.90 DE 4002501**

(43) Veröffentlichungstag der Anmeldung :
**19.11.92 Patentblatt 92/47**

(45) Bekanntmachung des Hinweises auf die
Patenterteilung :
**17.11.94 Patentblatt 94/46**

(84) Benannte Vertragsstaaten :
**AT BE CH DE DK ES FR GB IT LI LU NL SE**

(56) Entgegenhaltungen :
**EP-A- 0 252 321**
**EP-A- 0 280 321**
**EP-A- 0 308 194**
**EP-A- 0 329 148**
**Derwent's abstract, No 88 - 55 977/08, SU 1 325 705. publ. Woche 8808 VERTELETSKII A G**

(73) Patentinhaber : **Deutsche Thomson-Brandt GmbH**
**Postfach 1307**
**D-78003 Villingen-Schwenningen (DE)**

(72) Erfinder : **BRUNHEIM, Rüdiger**
**Alderring 24**
**D-7730 Villingen (DE)**

(74) Vertreter : **Einsel, Robert, Dipl.-Ing.**
**Deutsche Thomson-Brandt GmbH**
**Patent- und Lizenzabteilung**
**Göttinger Chaussee 76**
**D-30453 Hannover (DE)**

EP 0 513 033 B1

## Beschreibung

Die Erfindung betrifft ein Verfahren zur Umwandlung eines digitalen Signals in ein analoges Signal.

Ein solches Verfahren ist bekannt aus EP-A-0280321, wobei dort nur ein Teil des digitalisierten Signals oder der Dualzahl mit wenigstens einem Korrekturfaktor verknüpft wird. Der Korrekturfaktor wird von dem Teil des digitalisierten Signals oder der Dualzahl ausgewählt, der nicht mit dem Korrekturfaktor verknüpft wird. Außerdem weist die D/A-Wandleranordnung nach der EP-A-0280321 zwei separate D/A-Wandler auf, denen ein analoger Addierer nachgeschaltet ist. Des weiteren ist lediglich eine D/A-Wandlung von Festkomma-Dualzahlen möglich, jedoch keine exakte D/A-Wandlung von Gleitkomma-Dualzahlen.

EP-A-0329148 beschreibt eine D/A-Wandleranordnung für Gleitkomma-Zahlen. Eine Korrektur erfolgt durch Verwendung nur eines Teils des digitalen Signals als Mantisse. Zur Verbesserung der Genauigkeit wird die umzuwandelnde Mantisse durch einen 'digital shift circuit' aus dem eingehenden digitalen Signal selektiert. Jedoch wird die Mantisse dadurch nicht mit einem Korrekturfaktor arithmetisch verknüpft.

Gemäß der vorliegenden Erfindung ist das digitale Signal als Dualzahl generiert, vorzugsweise als Gleitkomma-Dualzahl. Eine Gleitkomma-Dualzahl besteht aus einer Mantisse mit M Bits und einem Exponenten zur Basis einer 2er-Potenz mit E Zuständen.

Mittels einer D/A-Wandleranordnung, die beispielsweise aus einem D/A-Wandler, dem die Mantisse der Gleitkomma-Dualzahl zugeführt wird, und einem dem D/A-Wandler nachgeschalteten schaltbaren Bewerter besteht, der durch den Exponenten der Gleitkomma-Dualzahl gesteuert wird, wobei die D/A-Wandleranordnung gegebenenfalls mit Toleranzfehlern behaftet ist, wird das digitale Signal in ein entsprechendes analoges Signal umgesetzt.

Eine wie oben beschriebene Gleitkomma-Darstellung wird nicht nur in Rechenanlagen, sondern auch in PC's, Voll-Digital-Verstärkern, digitalen Vorverstärkern und auch in Signalprozessoren eingesetzt und häufig durch Arithmetik-Prozessoren unterstützt.

Um der Gleitkomma-Dualzahl-Darstellung gerecht zu werden, sollte der Bewerter exakt in Potenzen der Basis des Exponenten teil- bzw. schaltbar (z.B. 1, $\frac{1}{2}$, $\frac{1}{4}$, 1/8, 1/16) sein, was häufig durch eine sehr genau abgeglichene Teilerschaltung in dem Bewerter gewährleistet wird.

Der schaltbare Bewerter, der auch als schaltbare Verstärkung bezeichnet wird, wird dabei vom Exponenten der Gleitkomma-Dualzahl gesteuert, so daß immer die richtige Skalierung der Wandlerwerte vorgenommen bzw. immer die richtige Schaltungsstufe ausgewählt wird.

Das Problem und der Nachteil bei dieser Art der Digital-Analog-Wandlung ist, daß die Genauigkeit der D/A-Wandlung sehr stark von der Genauigkeit der Skalierung der Schaltungsstufen des Bewerters abhängt, da sonst die analoge Skalierung nicht der Umrechnung im Digitalbereich bei der Bildung der Gleitkomma-Dualzahl entspricht. Die Schaltungsstufen sind jedoch häufig mit Toleranzfehlern behaftet. Um eine hinreichend große Genauigkeit und damit möglichst geringe Toleranzstufen oder -fehler der Schaltungsstufen bzw. der Skalierungsstufen zu gewährleisten, werden die Schaltungsstufen entweder mit sehr genauen Präzisions-Bauteilen realisiert oder mittels (Trimm-) Potentiometern zum exakten Abgleich nach Aufbau der Teilerschaltung (z.B. 1:$\frac{1}{2}$:$\frac{1}{4}$:1/8:1/16) der Verstärkung aufgebaut.

Während die Lösung mit den hochgenauen Bauteilen kostenintensiv ist, da diese Bauteile sehr teuer sind, weist die Lösung mit den Potentiometern Probleme bei der mechanischen und thermischen Langzeit-Stabilität der Bauteile auf.

Die der Erfindung zugrunde liegende Aufgabe besteht darin, ein Verfahren gemäß dem Oberbegriff des Anspruchs 1 zu entwickeln und zu verbessern, das eine im wesentlichen exakte Wandlung digitaler Signale in analoge Signale gewährleistet.

Im Prinzip wird die Aufgabe dadurch gelöst, daß die Dualzahl mit wenigstens einem Toleranzfehler ausgleichenden Korrekturfaktor arithmetisch verknüpft wird der durch die umzuwandelnde Dualzahl selbst ausgewählt wird. Vorzugsweise wird jeder bzw. jeder benötigte Korrekturfaktor abgespeichert, einer oder mehreren verschiedenen Dualzahlen zugeordnet.

Ist die Dualzahl als Gleitkomma-Dualzahl generiert, wird die Mantisse der Gleitkomma-Dualzahl mit einem oder mehreren Toleranzfehler ausgleichenden Korrekturfaktor oder -faktoren arithmetisch verknüpft, wobei die arithmetische Verknüpfung zweckmäßigerweise eine Multiplikation und/oder Addition ist.

Durch die Erfindung entfällt der genaue Abgleich der Skalierungsstufen im analogen Teil der D/A-Wandleranordnung. Stattdessen wird der Mantissenwert, der dem D/A-Wandler zugeführt wird, durch eine arithmetische Verknüpfung mit einem Korrekturfaktor so an die ungenaue Skalierung der durch den Exponenten der Gleitkomma-Dualzahl angesteuerten Schaltungsstufe (vor-)angepaßt, daß sich nach der Skalierung der korrekte, analoge Ausgangswert ergibt. Dadurch wirkt sich ein Toleranzfehler einer Schaltungsstufe nicht mehr fehlerhaft auf die Bewertung einer Gleitkomma-Dualzahl bzw. auf ein digitales Signal aus.

Es wird also statt eines analogen Abgleichs der Skalierungsstufen ein digitaler Abgleich vorgenommen.

2

Außerdem kann mittels der Erfindung ein (bzw. mehrere) systematischer Umsetzungsfehler des D/A-Wandlers selbst durch eine geeignete Korrektur auf der digitalen Seite des D/A-Wandlers so berichtigt werden, daß am Ausgang ein exakter Umsetzwert eines digitalen Eingabewertes liegt.

Durch die Voranpassung des Mantissenwertes auf die Ungenauigkeit bzw. Toleranzfehler der jeweils ausgewählten Schaltungsstufe des Verstärkers oder des D/A-Wandlers, wird in überraschender Weise ein einfaches Verfahren bereitgestellt, daß unempfindlich ist gegenüber Bauteilfehlern und thermischen und mechanischen Einflüssen und in einfacher Weise einen Verzicht auf teure Bauelemente bzw. -teile ermöglicht.

Bei der Gleitkomma-Darstellung der Dualzahl ist es zweckmäßig, daß der Korrekturfaktor zur Korrektur des oder der Fehler des Bewerters abgespeichert wird und wie die Schaltungsstufen des Bewerters durch den Exponenten der Gleitkomma-Dualzahl der entsprechende Korrekturfaktor ausgewählt wird. Als arithmetische Verknüpfung dieser derart ausgewählten Korrekturfaktoren ist eine Multiplikation sinnvoll.

Vorzugsweise wird die Mantisse der Gleitkomma-Dualzahl jeweils mit zwei Korrekturfaktoren arithmetisch verknüpft, wobei der erste Korrekturfaktor durch den Exponenten (wie oben beschrieben) und der zweite Korrekturfaktor durch die Mantisse der Gleitkomma-Dualzahl ausgewählt werden. Als arithmetische Verknüpfung des zweiten Korrekturfaktors mit der Mantisse ist eine Addition zweckmäßig. Der zweiten Korrekturfaktor dient zur (Vor-)Berichtigung eines systematischen Umsetzungsfehlers des D/A-Wandlers selbst.

Ist die Dualzahl in Festkomma-Darstellung generiert, wird der Korrekturfaktor durch die Festkomma-Dualzahl selbst ausgewählt. Hier zeigt sich, daß die Erfindung keineswegs auf Dualzahlen in Gleitkomma-Darstellung beschränkt ist, denn eine Berichtigung systematischer D/A-Wandler-Fehler läßt sich ebenfalls mit der Erfindung durch den Festkomma-Zahlenwert vornehmen.

Des weiteren geht die Erfindung aus von einer D/A-Wandleranordnung zur Umwandlung eines digitalen Signals in ein analoges Signal, wobei das digitale Signal vorzugsweise als Gleitkomma-Dualzahl oder Festkomma-Dualzahl generiert ist und die D/A-Wandleranordnung im wesentlichen aus einem D/A-Wandler besteht, dessen Ausgang mit dem Eingang eines schaltbaren Bewerters verbunden ist, der wenigstens zwei Schaltungsstufen enthält, die gegebenenfalls mit Toleranzfehlern behaftet sind. Die Schaltungsstufen sind vom Exponenten der Gleitkomma-Dualzahl steuerbar.

Diesbezüglich liegt der Erfindung die weitere Aufgabe zugrunde, eine D/A-Wandleranordnung vorzusehen, die eine im wesentlichen zuverlässige Wandlung eines digitalen Signals in ein analoges Signal durchführt.

Diese Aufgabe wird bei einer oben beschriebenen D/A-Wandleranordnung im Prinzip dadurch gelöst, daß der Eingang des D/A-Wandlers mit dem Ausgang einer arithmetischen Recheneinheit verbunden ist, die die umzuwandelnde Dualzahl bzw. die Mantisse der Gleitkomma-Dualzahl mit wenigstens einem Toleranzfehler ausgleichenden Korrekturfaktor verknüpft.

Dazu ist es von Vorteil, daß die den Schaltungsstufen zugeordneten Korrekturfaktoren in einem von dem Exponenten und/oder der Mantisse der Gleitkomma-Dualzahl adressierbaren bzw. steuerbaren Speicher, vorzugsweise einem Programmable-Read-Only-Memory (PROM) abgelegt sind.

Steuerbare Speicher, insbesondere PROMs sind als zuverlässige Standardbauteile in vielen unterschiedlichen Arten und Größenordnungen günstig erhältlich. Ihre Programmierung ist einfach und direkt möglich ebenso wie die Anordnung der Recheneinheit oder der -einheiten.

Außerdem ist zweckmäßig, wenn der schaltbare Bewerter aus einem Widerstandsnetzwerk besteht, das die Ausgangsspannung des D/A-Wandlers in Stufen von Zweier-Potenzen herunterteilt und dessen Abgriffe einem Multiplexer zugeführt sind, der von dem Exponenten der Gleitkomma-Dualzahl steuerbar ist. Der Ausgang des Multiplexers ist dazu vorzugsweise mit dem Eingang eines Impedanzwandlers verbunden, dessen Ausgang den analogen Ausgang der D/A-Wandleranordnung darstellt.

Des weiteren ist es von Vorteil, wenn ein digitaler Signalprozessor vorgesehen ist, der im digitalen Teil der Wandleranordnung die Ansteuerung vom D/A-Wandler und des schaltbaren Bewerters ausführt, den Speicher mit den Korrekturdaten und die Recheneinheit enthält und die Korrektur der Dualzahlen bzw. der Mantissedaten und damit einen halb- oder vollautomatischen Abgleich und Berichtigung der Schaltungsstufen-Fehler des Bewerters und/oder der systematischen Fehler des D/A-Wandlers vornimmt.

Weiterbildungen und vorteilhafte Ausgestaltungen des Verfahrens und der D/A-Wandleranordnung ergeben sich aus den Unteransprüchen, der weiteren Beschreibung und in Zeichnungen dargestellten Ausführungsbeispielen.

Die Zeichnungen zeigen in:

Fig. 1      ein Schaltbild einer bekannten D/A-Wandleranordnung mit einem schaltbaren Bewerter

Fig. 2      ein Schaltbild der Wandleranordnung wie in Fig. 1 mit einem Ausführungsbeispiel eines schaltbaren Bewerters

Fig. 3      ein Schaltbild einer D/A-Wandleranordnung gemäß der Erfindung

Fig. 4      ein Schaltbild einer D/A-Wandleranordnung mit einem digitalen Signalprozessor zum automatischen Abgleich des Skalierungsfehlers.

Fig. 5 ein Flußdiagramm für einen Digitalen-Signal-Prozessor zur Erzeugung einer Gleitkomma-Dual zahl aus einer Festkomma-Dualzahl und der Korrektur der Mantisse.

Fig. 6 ein Schaltbild einer D/A-Wandleranordnung mit einer Vorkorrektur von systematischen D/A-Wandler-Umsetzungsfehlern

Fig. 7 ein Schaltbild mit der Kombination aus Fig. 3 und Fig. 6.

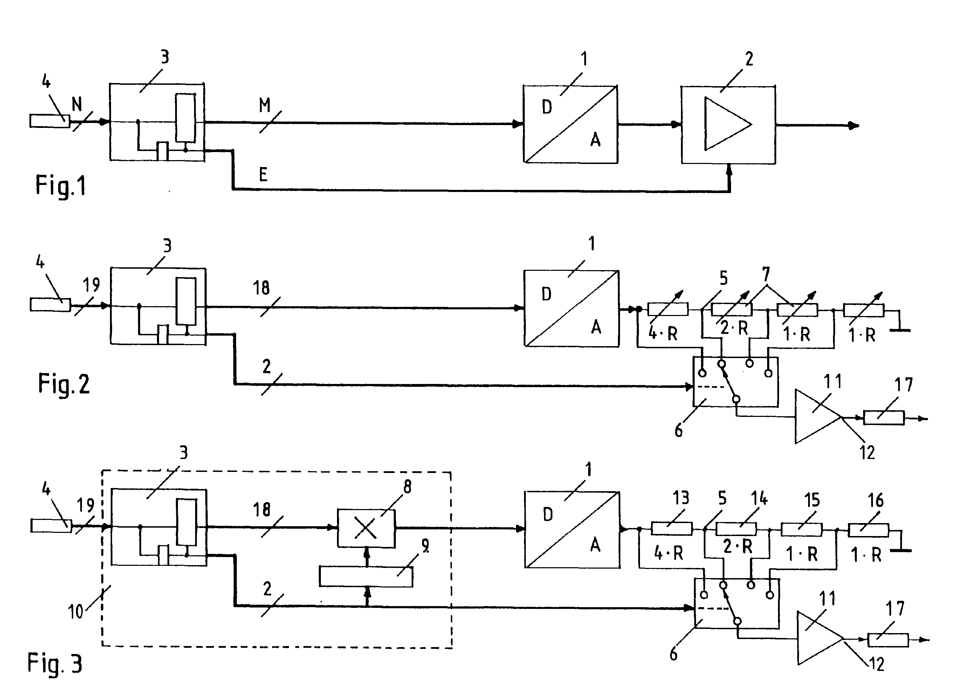

Fig. 1 zeigt eine D/A-Wandleranordnung mit einem herkömmlichen D/A-Wandler 1 mit M Bits Auflösung, der eingangsseitig die Mantisse einer Gleitkomma-Dualzahl mit M Bits empfängt. Ausgangsseitig ist dem D/A-Wandler ein schaltbarer Bewerter oder Verstärker 2 nachgeschaltet, der durch den Exponenten der Gleitkomma-Dualzahl gesteuert wird und E Schaltungszustände annehmen kann.

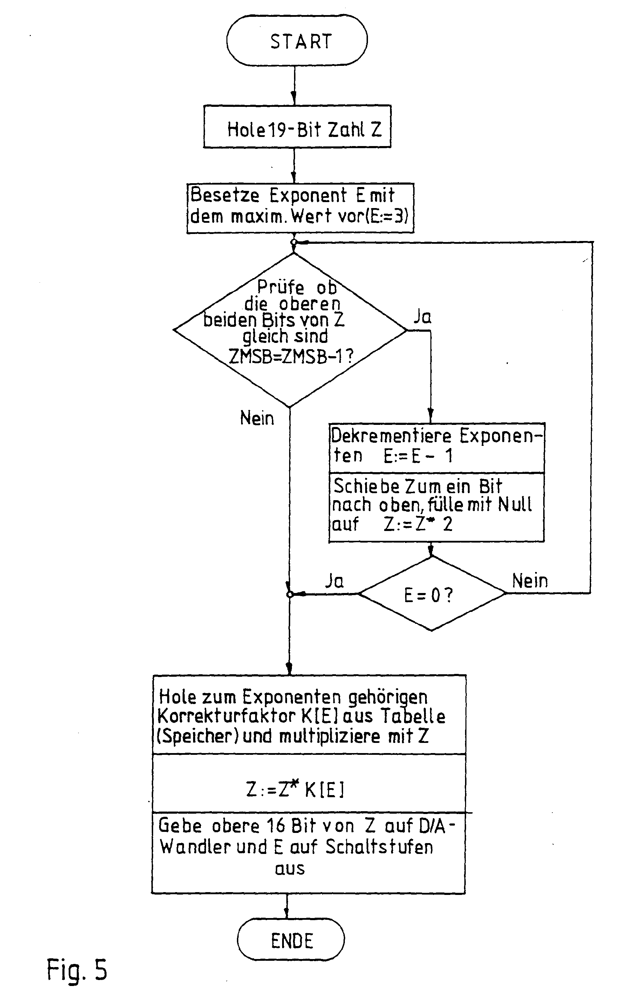

Wie in Fig. 1 zu sehen, wird die Gleitkomma-Dualzahl mittels einer Aufbereitungslogik 3 aus einem digitalen Signal 4 mit N Bits in Festkomma-Dualzahl-Darstellung erzeugt. Hierzu werden die oberen E Bits des Signals 4 überprüft. Sind (in 2er-Komplemente-Darstellung) von diesen E Bit die oberen X Bit gleich, so erhält der Exponent den Wert E - X und die 2er-Komplement-Zahl wird um X - 1 Bit nach links geschoben (siehe Fig. 5). Dann bilden die oberen M Bits der so geschobenen Zahl die Mantisse. Sind die oberen beiden Bit der Zahl ungleich (kein Bit gleich), so ist der Exponent Null und es wird nicht geschoben, da alle Bits signifikant sind (siehe auch Fig. 5).

Um der Gleitkomma-Dualzahlen-Darstellung Rechnung zu tragen, muß die schaltbare Verstärkung oder der Bewerter 2 exakt in Potenzen der Zahl 2 schaltbar sein, wie in Fig. 2 (1, ½, ¼) gezeigt. Diese Anordnung deckt dann einen Wertebereich ab, der einem linearen Wandler mit M + E - 1 Bit Auflösung entspricht. Bei dem D/A-Wandler 1 in Fig. 2 ist die Mantisse 16 Bit, der Exponent 2 Bit und das digitale Signal 4 19 Bit breit. Der Exponent kann also maximal 4 verschiedene Zustände annehmen. Die Genauigkeit dieser Darstellung hängt stark von der Genauigkeit und damit von den Toleranzfehlern der Bewerterstufen/Verstärkerstufen ab.

Eine Möglichkeit, den umschaltbaren Bewerter 2 zu realisieren, ist wie in Fig. 2 gezeigt, ein Widerstandsnetzwerk 5, daß die Ausgangsspannung des D/A-Wandlers 1 in Stufen von 2er-Potenzen herunterteilt, und dessen einzelne Abgriffe einem Multiplexer 6 (CMOS-Schalter) zugeführt sind. Der Multiplexer 6 wird vom Exponenten der Gleitkomma-Dualzahl gesteuert, so daß immer die richtige Skalierung des Wandlerwertes vorgenommen wird. Dabei kann der Multiplexer 6 in diesem Fall (Fig. 3) vier verschiedene Schaltzustände annehmen. Die Widerstände 7 des Teilernetzwerkes 5 müssen jedoch sehr genau sein, da sonst die analoge Skalierung nicht der Umrechnung im Digitalbereich bei der Bildung der Gleitkomma-Dualzahl entspricht. Diese Genauigkeit wurde bisher durch einen genauen Abgleich der Widerstände 7 bei der Fertigung oder durch nachträgliches Abgleichen beim Aufbau mittels Trimm-Potentiometern 7 erreicht, wie in Fig. 2 gezeigt. Ein Abgleich mittels Potentiometer gestaltet sich jedoch schwierig, da ein Abgleich eines Potentiometers das gesamte Teilerverhältnis einer Schaltungsstufe zu den anderen Schaltungsstufen verändert. Der Ausgang des Multiplexers 6 ist mit dem Eingang eines Impedanzwandlers 11 verbunden, dessen Ausgang 12 wiederum mit dem Eingang eines Haltegliedes 17 verbunden ist.

Bei der in Fig. 3 dargestellten D/A-Wandleranordnung, entfällt der genaue Abgleich der Skalierungsstufen, d. h. der Widerstände 13-16 des Widerstandsnetzwerk 5 im analogen Teil des Wandlers. Stattdessen wird der Mantissenwert jeder Gleitkommazahl, der dem herkömmlichen D/A-Wandler zugeführt wird, durch Multiplikation in einem Multiplizierer 8 mit einem Korrekturfaktor so an die ungenaue Skalierung angepaßt, daß sich nach der Skalierung der korrekte Ausgangswert ergibt. Dabei ist jeder vom Exponenten ausgewählten Schaltungsstufe ein entsprechender den Toleranzfehler dieser Schaltungsstufe ausgleichender Korrekturfaktor zugeordnet und dieser in einer Speichereinheit, hier dem Festwertspeicher 9 abgelegt.

Es wird also statt einer analogen eine digitale Skalierung eingesetzt. Dieses Verfahren ist unempfindlich gegenüber thermischen oder mechanischen Einflüssen und ermöglicht zusätzlich einen einfachen halb- oder voll- automatischen Abgleich.

Es ist z.B. möglich, die Korrekturfaktoren beim Aufbau des Netzwerkes 5 zu ermitteln und sie in einen Festwertspeicher 9 (z.B. PROM/ROM etc) abzulegen, der durch den Exponenten E der Gleitkomma-Dualzahl adressiert wird und seine Daten dem Multiplizierer 8 zuführt, der wiederum die Mantissedaten korrigiert.

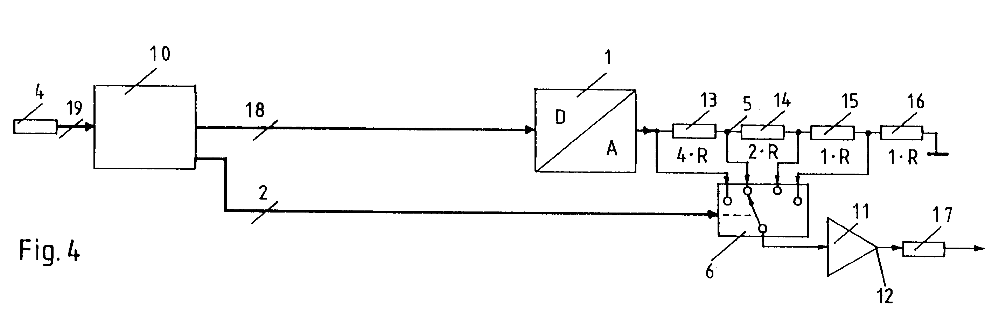

Die Anordnung aus Aufbereitungslogik 3 und Festwertspeicher 9 /Multiplizierer 8 läßt sich günstig durch einen Digitalen-Signal-Prozessor(DSP) 10 ersetzen, der die Dekodierung in Exponent und Mantisse und die Korrektur in einer Einheit übernimmt, wie in Fig. 4 gezeigt. Fig. 5 zeigt das Flußdiagramm für einen DSP zur Generierung der Gleitkomma -Dualzahl aus der Festkomma-Dualzahl und der Korrektur der Mantisse. Darüber hinaus ist der DSP 10 durch seine zusätzliche Schaltungslogik (nicht dargestellt) in der Lage, über von außen zugeführte Meßergebnisse z.B. eines Klirrfaktor-Analysators oder eines anderen geeigneten Gerätes, einen halb- oder vollautomatischen Abgleich der Skalierungsfehler vorzunehmen.

Hierzu werden schrittweise die Korrekturfaktoren geändert, bis der Fehler im Signal minimal ist. Die endgültigen Werte werden dann dauerhaft abgespeichert. Dies ist z.B. in einem EEPROM, EPROM oder einem SRAM mit Batteriepufferung möglich.

Im folgenden wird das Beispiel für eine Korrektur beschrieben:

Wie in Fig. 3 gezeigt, hat das digitale Signal 4 eine Breite von 19 Bit, die Mantisse 16 Bit und der Exponent 2 Bit (alle 2er-Komplement). Der D/A-Wandler weist eine Auflösung von 16 Bit auf. Der Multiplizierer führt die Multiplikation eines 16 Mantissendatums mit einem 15 Bit breiten Korrekturdatum auf ein neues 16 Bit breites Mantissendatum. Die Ausgangsspannung des Wandlers liegt bei Vollaussteuerung (32768) bei 1 V.

Es sei die Grundgenauigkeit der Widerstände der Teilerkette bei ± 1% angenommen.

Die Widerstände 13, 14 und 15 weichen um 1% nach oben ab (Summe 7.07R), der Widerstand 16 weicht um 1% nach unten ab (0.99R).

Es resultiert ein Teiler-Verhältnis von Tv1= 0.99/8.06 für die unterste Stufe mit dem Exponenten 0 (Sollverhältnis Tv= =1/8). Diese Stufe hat also eine Abweichung von -1.74%.

Berechnung der Korrekturfaktoren:

Bei einer Festkomma-Multiplikation sind nur Korrektur-Faktoren mit Werten < 1 möglich.

Damit Abweichungen nach oben und nach unten korrigiert werden können, wird der Korrekturfaktor für die fehlerfreie direkte Stufe 17 (Exponent 3) auf den Wert 32000 gesetzt. Die übrigen Korrekturfaktoren sind relativ zu diesem Faktor zu berechnen. Somit sind Korrekturen um ca. 2% nach oben möglich.

Es ergibt sich für alle Werte eine Verstärkungsänderung um 32000/32768, die jedoch nur die Amplitude des Signals leicht verringert, die Qualität des Signals jedoch nicht verschlechtert.

Der Korrekturfaktor für die Stufe 0 berechnet sich also zu

$$K0 = K3 * Tv0 / Ti= = 32000 * 8.06 / 0.99 / 8$$
$$= 32566(\text{gerundet auf 15 Bit})$$

Für das Eingangsdatum 32767 folgt:

Mantisse = 32767; Exponent = 0

Die Mantisse muß mit dem Faktor K0 = 32566 multipliziert werden. Bei einer Festkomma-Multiplikation mit anschließendem Schneiden auf 16 Bit ergibt sich der Wert 32565 für den Wandler. Die erzeugte Ausgangsspannung beträgt 0.993804932 V.

Diese Spannung wird jetzt durch die Teilerstufe 0 auf 0.122067851 heruntergeteilt.

Der Sollwert für den Ausgang beträgt (unter Berücksichtigung des Korrekturfaktors für die Stufe 3, der sich in einer Änderung der Verstärkung äußert)

$$32767 / 8 * 1V / 32768 * 32000 / 32768 = 0.122066587 V.$$

Der Fehler beträgt auf die Vollaussteuerung bezogen -0.0001265% (=19Bit).

Wird jetzt unterstellt, daß auch der D/A-Wandler selbst eine systematisch fehlerhafte Umsetzung einiger oder aller digitalen Signale vornimmt -diese Fehler werden als systematische Fehler bezeichnet- so läßt sich eine solche fehlerhafte Umsetzung ebenfalls mit dem Prinzip der Erfindung, nämlich dem digitalen Vorabgleich, vermeiden. Dabei ist gleich, welcher Art die digitalen Signale sind, ebenso ist die Korrektur der digitalen Signale nicht auf eine bestimmte Darstellung der Dualzahlen festgelegt.

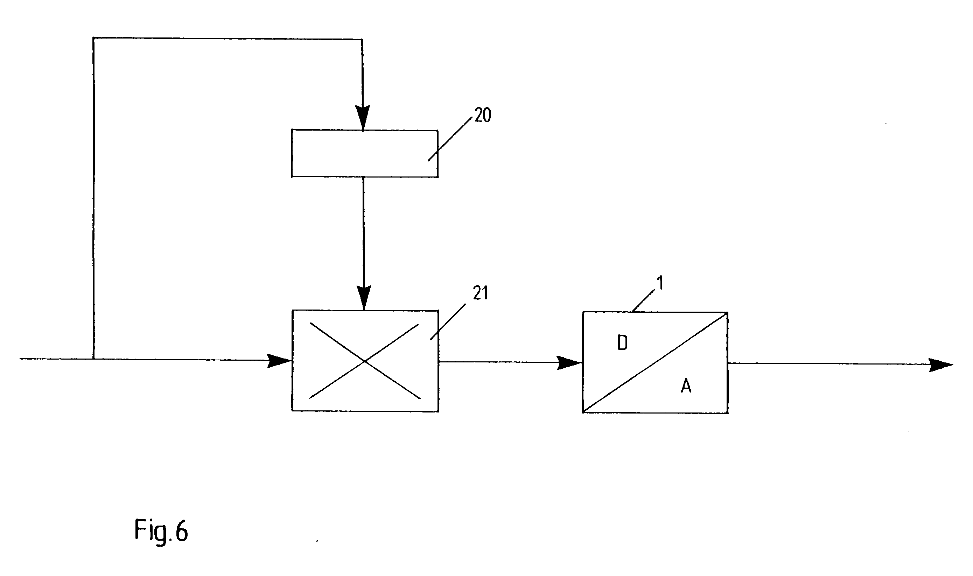

Wie in Fig. 6 gezeigt, wird der Mantissenwert oder der Festkomma-Zahlenwert zur Adressierung eines Speichers benutzt. Im Speicher sind für alle D/A-Wandler-Umsetzungsfehler geeignete Korrekturfaktoren abgelegt und über eine entsprechende Adressierung werden die geeigneten Korrekturfaktoren von dem ankommenden digitalen Signal ausgewählt. Die ausgewählten Korrekturfaktoren werden in einer weiteren aritmetischen Recheneinheit 21 mit von angewählten Mantissenwert oder Festkomma-Zahlenwert verknüpft. Es ist sinnvoll wenn diese Verknüpfung eine Addition und/oder Subtraktion ist. Somit wird dem D/A-Wandler ein entsprechend auf Fehler des D/A-Wandlers voreingestellter Mantissenwert oder Festkomma-Zahlenwert zugeführt, sodaß der analoge Wert am Ausgang des D/A-Wandlers exakt dem digitalen Wert am Eingang der Schaltung in Fig. 6 entspricht.

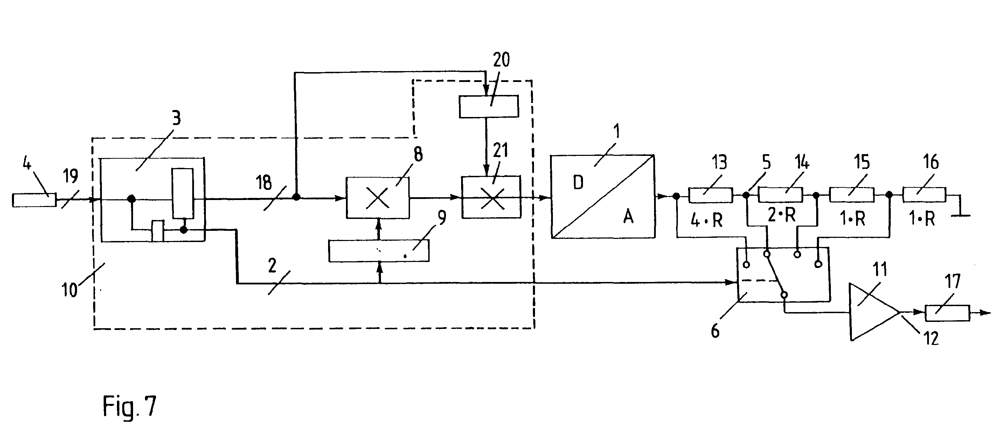

Fig. 7 zeigt schließlich eine Kombination beider voran beschriebenen Korrekturformen, wobei die Recheneinheit 21 im Signalweg zum D/A-Wandler vor oder hinter der Recheneinheit liegen kann. Ein sehr zweckmäßige ist es, wenn eine gemeinsamen Recheneinheit die Aufgabe der oben beschriebenen Recheneinheiten übernimmt und zu korrigierende digitale Signale mittels Multiplikation und/oder Addition/Subtraktion mit ausgewählten Korrekturfaktoren auf Fehler in der D/A-Wandleranordnung vorkompensiert, sodaß am Ausgang der Schaltung ein hochgenauer analoger Wert anliegt.

Die Aufzählung der Fehler der D/A-Wandleranordnung ist keineswegs vollständig. Mittels der Erfindung können auch weitere Fehler, die hier nicht erwähnt werden, der D/A-Wandleranordnung korrigiert werden. Auch ist das erfinderische Verfahren und die Einrichtung nicht auf die Umwandlung eines einzigen digitalen Signals beschränkt, sondern auch auf die Umwandlung einer Mehrzahl von digitalen Daten oder eines digitalen Datenstroms anwendbar.

**Patentansprüche**

1. Verfahren zur Umwandlung eines digitalen Signals in ein analoges Signal mittels einer D/A-Wandleranordnung, der das digitale Signal zugeführt wird, wobei das digitale Signal als Festkomma-Dualzahl generiert ist und die D/A-Wandleranordnung gegebenenfalls mit einem systematischen Umsetzfehler behaftet ist, der mit einem Korrekturfaktor ausgeglichen werden kann, **dadurch gekennzeichnet**, daß die D/A-Wandleranordnung aus einem einzigen D/A-Wandler (1) besteht und daß die gesamte Festkomma-Dualzahl vor der D/A Umwandlung mit dem den Umsetzfehler ausgleichenden Korrekturfaktor arithmetisch verknüpft wird, wobei dieser Korrekturfaktor von der gesamten Festkomma-Dualzahl ausgewählt wird.

2. Verfahren nach Anspruch 1, **dadurch gekennzeichnet**, daß der Korrekturfaktor abgespeichert und jeweils wenigstens einer Festkomma-Dualzahl zugeordnet ist.

3. Verfahren zur Umwandlung eines digitalen Signals in ein analoges Signal mittels einer D/A-Wandleranordnung, der das digitale Signal zugeführt wird, wobei die D/A-Wandleranordnung gegebenenfalls mit einem Toleranzfehler behaftet ist und das digitale Signal als Gleitkomma-Dualzahl generiert ist, die aus einer Mantisse und einem Exponenten zur Basis einer Zweierpotenz mit E Zuständen besteht, **dadurch gekennzeichnet**, daß die Mantisse der Gleitkomma-Dualzahl mit wenigstens einem einen Toleranzfehler ausgleichenden Korrekturfaktor arithmetisch verknüpft wird, wobei der Korrekturfaktor durch den gesamten Exponenten ausgewählt wird.

4. Verfahren nach Anspruch 3, **dadurch gekennzeichnet**, daß die Mantisse der Gleitkomma-Dualzahl mit zwei Korrekturfaktoren arithmetisch verknüpft wird, wobei der erste Korrekturfaktor durch den Exponenten und der zweite Korrekturfaktor durch die Mantisse der Gleitkomma-Dualzahl ausgewählt wird.

5. Verfahren nach Anspruch 4, **dadurch gekennzeichnet**, daß als Verknüpfung des ersten Korrekturfaktors mit der Mantisse eine Multiplikation und daß als Verknüpfung des zweiten Korrekturfaktors mit der Mantisse eine Addition durchgeführt wird.

6. D/A-Wandleranordnung (1, 2) zur Durchführung des Verfahrens nach einem der Ansprüche 1 - 5, **dadurch gekennzeichnet**, daß der Eingang eines D/A-Wandlers (1) mit dem Ausgang einer ersten und/oder zweiten arithmetischen Recheneinheit (8, 21) verbunden ist, die ein umzuwandelndes digitales Signal mit wenigstens einem einen Toleranzfehler und/oder einen systematischen Umsetzfehler ausgleichenden Korrekturfaktor verknüpft, wobei das digitale Signal als Festkomma- oder Gleitkomma-Dualzahl generiert ist und wobei der Korrekturfaktor von dem gesamten Exponenten oder von der gesamten Festkomma-Dualzahl ausgewählt wird.

7. D/A-Wandleranordnung nach Anspruch 6, **dadurch gekennzeichnet**, daß die Korrekturfaktoren in einem adressierbaren Speicher (9, 20) abgelegt sind, der durch das digitale Signal selbst adressierbar ist, und daß der einem digitalen Signal zugeordnete Korrekturfaktor durch das digitale Signal selbst auswählbar ist.

8. D/A-Wandleranordnung nach einem der Ansprüche 6 oder 7, aber außer 1 und 2, **dadurch gekennzeichnet**, daß das digitale Signal als Gleitkomma-Dualzahl generiert ist, die jeweils aus einer Mantisse und einem Exponenten zur Basis einer Zweier-Potenz mit E Zuständen besteht, und daß die D/A-Wandleranordnung besteht aus einem D/A-Wandler (1), der gegebenenfalls mit systematischen Umsetzfehlern behaftet ist und dessen Ausgang mit dem Eingang eines schaltbaren Bewerters (2) verbunden ist, der wenigstens zwei Schaltungsstufen enthält, die gegebenenfalls mit Toleranzfehler behaftet sind, und daß der Eingang des D/A-Wandlers (1) mit dem Ausgang der ersten arithmetischen Recheneinheit (8) verbunden ist, die die Mantisse der Gleitkomma-Dualzahl mit wenigstens einem einen Toleranzfehler ausgleichenden Korrekturfaktor verknüpft.

9. D/A-Wandleranordnung nach Anspruch 8, **dadurch gekennzeichnet**, daß die Korrekturfaktoren in einem von dem Exponenten und/oder der Mantisse der Gleitkomma-Dualzahl adressierbaren bzw. steuerbaren Speicher (9, 20), vorzugsweise einem Programmable-Read-Only-Memory (PROM), abgelegt sind.

10. D/A-Wandleranordnung nach Anspruch 8 oder 9, **dadurch gekennzeichnet**, daß der schaltbare Bewerter (2) aus einem Widerstandsnetzwerk (5) besteht, das die Ausgangsspannung des D/A-Wandlers in Stufen von Potenzen der Basis des Exponenten herunterteilt und dessen Abgriffe einem Multiplexer (6) zugeführt sind, der von dem Exponenten der Gleitkomma-Dualzahl steuerbar ist.

11. D/A-Wandleranordnung nach Anspruch 10, **dadurch gekennzeichnet**, daß der Ausgang des Multiplexers (6) mit dem Eingang eines Impedanzwandlers (11) verbunden ist, und daß der Ausgang des Impedanzwandlers mit einem Halteglied (17) verbunden ist.

12. D/A-Wandleranordnung nach einem der Ansprüche 7 - 11, **dadurch gekennzeichnet**, daß ein digitaler Signalprozessor (10) vorgesehen ist, der im digitalen Teil der Wandleranordnung einen halb- oder vollautomatischen Abgleich der Schaltungsstufenfehler vornimmt und die erste und/oder zweite arithmetische Recheneinheit (8, 21) und den adressierbaren bzw. steuerbaren Speicher (9, 20) enthält.

13. D/A-Wandleranordnung nach einem der Ansprüche 7 - 12, **dadurch gekennzeichnet**, daß der Speicher (9) von dem Exponenten der Gleitkomma-Dualzahl angesteuert wird, der den ersten Korrekturfaktor auswählt, der in der ersten Recheneinheit (8) mit der Mantisse der Gleitkomma-Dualzahl multiplikativ verknüpft wird,
und/oder daß die Mantisse der Gleitkomma-Dualzahl den zweiten Korrekturfaktor aus dem adressierbaren bzw. steuerbaren Speicher (20) auswählt, der der Mantisse der Gleitkomma-Dualzahl in der zweiten Recheneinheit (21) additiv zuführbar ist.

14. D/A-Wandleranordnung nach Anspruch 13, **dadurch gekennzeichnet,** daß die zweite arithmetische Recheneinheit (21) im Signalweg zum D/A-Wandler vor oder hinter der ersten arithmetischen Recheneinheit (8) angeordnet ist.

## Claims

1. A method for converting a digital signal to an analog signal by means of a D/A converter arrangement to which the digital number is fed, in which the digital signal is generated as a fixed point dual number and the D/A converter arrangement may be subject to a systematic conversion error which can be compensated by a correction factor, characterised in that the D/A converter arrangement consists of a single D/A converter (1) and in that before the D/A conversion the entire fixed point dual number is arithmetically combined with the correction factor compensating the conversion error, the correction factor being selected by the entire fixed point dual number.

2. A method according to claim 1, characterised in that the correction factor is stored and is in each case assigned to at least one fixed point dual number.

3. A method for converting a digital signal to an analog signal by means of a D/A converter arrangement to which the digital signal is fed, in which the D/A converter arrangement may be subject to a tolerance error and the digital signal is generated as a floating point dual number consisting of a mantissa and an exponent on the base of a power of two with E conditions, characterised in that the mantissa of the floating point dual number is arithmetically combined with at least one correction factor compensating tolerance errors, on which the correction factor is selected by the whole exponent.

4. A method according to claim 3, characterised in that the mantissa of the floating point dual number is arithmetically combined with two correction factors, in which the first correction factor is selected by the exponent and the second correction factor by the mantissa of the floating point dual number.

5. A method according to claim 4, characterised in that a multiplication is performed to combine the first correction factor with the mantissa, and in that an addition is performed to combine the second correction factor with the mantissa.

6. A D/A converter arrangement (1,2) for executing the process according to any one of claims 1-5, characterised in that the input of a D/A converter (1) is connected to the output of a first and/or second arithmetic computational unit (8,21) which combines a digital signal to be converted with at least one correction factor compensating a tolerance error and/or a systematic conversion error, in which the digital signal is generated as a fixed point or floating point dual number and in which the correction factor is selected by the entire exponent or by the entire fixed point dual number.

7. A D/A converter arrangement according to claim 6, characterised in that the correction factors are stored in an addressable memory (9,20) which can be addressed by the digital signal itself and the correction factor assigned to a digital signal can be selected by the digital signal itself.

8. A D/A converter arrangement according to claim 6 or 7 but excluding 1 and 2, characterised in that the digital signal is generated as a floating point dual number which consists in each case of a mantissa and an exponent on the base of a power of two with E conditions, and in that the D/A converter arrangement consists of a D/A converter (1) which may be subject to systematic conversion errors and the output of which is connected to the input of a switchable evaluator (2) containing at least two switching stages which may be subject to tolerance errors, and in that the input of the D/A converter (1) is connected to the output of the first arithmetic computational unit (8) which combines the mantissa of the floating point dual number with at least one correction factor compensating tolerance errors.

9. A D/A converter arrangement according to claim 8, characterised in that the correction factors are stored in a memory (9,20) which can be addressed or controlled by the exponent and/or the mantissa of the floating point dual number, said memory preferably being a programmable read only memory (PROM).

10. A D/A converter arrangement according to claim 8 or 9, characterised in that the switchable evaluator (2) consists of a resistor network (5) which divides the output voltage of the D/A converter in steps of powers of the base of the exponent and the taps of which are fed to a multiplexer (6) which can be controlled by the exponent of the floating point dual number.

11. A D/A converter arrangement according to claim 10, characterised in that the output of the multiplexer (6) is connected to the input of an impedance converter (11), and in that the output of the impedance converter is connected to a holding element (17).

12. A D/A converter arrangement according to any one of claims 7-11, characterised in that a digital signal processor (10) is provided which performs a semi-automatic or fully automatic compensation of the switching stage errors in the digital section of the converter arrangement and contains the first and/or second arithmetic computational unit (8,21) and the addressable or controllable memory (9,20).

13. A D/A converter arrangement according to any one of claims 7-12, characterised in that the memory (9) is controlled by the exponent of the floating point dual number which selects the first correction factor which is combined through multiplication in the first computational unit (8) with the mantissa of the floating point dual number, and/or in that the mantissa of the floating point dual number selects the second correction factor from the addressable or controllable memory (20) which can be supplied through addition to the mantissa of the floating point dual number in the second computational unit (21).

14. A D/A converter arrangement according to claim 13, characterised in that the second arithmetic computational unit (21) is located in the signal path to the D/A converter before or after the first arithmetic computational unit (8).

## Revendications

1. Procédé de conversion d'un signal numérique en un signal analogique au moyen d'un dispositif de conversion numérique/analogique, qu'on alimente avec le signal numérique, ce signal numérique étant généré comme nombre binaire à virgule fixe et le dit dispositif de conversion étant, le cas échéant, entâché d'une erreur de conversion systématique, cette erreur de conversion pouvant être compensée par un coefficient de correction, **caractérisé en ce que** le dispositif de conversion numérique/analogique se compose d'un convertissuer numérique/analogique unique et que le nombre binaire à virgule fixe dans son entier est combiné arithmétiquement avant le décodage numérique/analogique avec un coefficient de correction compensant l'erreur de conversion, ce coefficient de correction étant sélectionné par le nombre binaire à virgule fixe dans son entier.

2. Procédé selon la revendication 1 **caractérisé en ce que** le coefficient de correction est mémorisé et attribué à au moins un nombre binaire à virgule fixe.

3. Procédé de conversion d'un signal numérique en un signal analogique au moyen d'un dispositif de conversion numérique/analogique, dans lequel on introduit le signal numérique, ce dispositif de conversion numérique/analogique étant, le cas échéant, entâché d'une erreur de tolérance et le dit signal numérique étant généré comme nombre binaire à virgule flottante se composant d'une mantisse et d'un exposant comme base d'une puissance deux à E états, **caractérisé en ce que** la mantisse du nombre binaire à virgule flottante est combiné arithmétiquement avec au moins un coefficient de correction compensant une erreur de tolérance, ce coefficient de correction étant sélectionné par l'exposant dans son entier.

4. Procédé selon la revendication 3 **caractérisé en ce que** la mantisse du nombre binaire à virgule flottante est combinée arithmétiquement avec deux coefficients de correction, le premier coefficient de correction étant sélectionné par l'exposant et le second coefficient de correction étant sélectionné par la mantisse du nombre binaire à virgule flottante.

5. Procédé selon la revendication 4 **caractérisé en ce que** la combinaison du premier coefficient de correction avec la mantisse s'effectue au moyen d'une multiplication et que la combinaison du second coefficient de correction avec la mantisse s'effectue au moyen d'une addition.

6. Dispositif de conversion numérique/analogique (1, 2) pour la réalisation du procédé selon une des revendications 1 - 5 **caractérisé en ce que** l'entrée d'un convertisseur numérique/analogique (1) est reliée à la sortie d'une première et/ou d'une seconde unité de calcul arithmétique (8, 21), cette unité arithmétique combinant un signal numérique à décoder avec au moins un coefficient de correction compensant une erreur de tolérance et/ou une erreur de conversion systématique, le signal numérique étant généré comme nombre binaire à virgule fixe ou flottante et le coefficient de correction étant sélectionné par l'exposant dans son entier ou par le nombre binaire à virgule fixe dans son entier.

7. Dispositif de conversion numérique/analogique selon la revendication 6 **caractérisé en ce que** les coefficients de correction sont stockés dans une mémoire adressable (9, 20), cette mémoire étant adressable au moyen du signal numérique luimême.

8. Dispositif de conversion numérique/analogique selon une des revendications 6 ou 7 **caractérisé en ce que** le signal numérique est généré comme nombre binaire à virgule flottante se composant et d'une mantisse et d'un exposant sur la base d'une puissance deux à E états et **que** le dispositif de conversion numérique/analogique se compose d'un convertisseur numérique/analogique (1), ce convertisseur étant, le cas échéant, entâché d'une erreur de conversion systématique et la sortie de ce convertisseur étant reliée avec l'entrée d'un évaluateur (2) commutable comportant au moins deux étages de circuit, ces étages de circuit étant, le cas échéant, entâchés d'une erreur de tolérance et **que** l'entrée du convertisseur numérique/analogique (1) est reliée avec la sortie d'une unité de calcul arithmétique (8), cette unité combinant la mantisse du nombre binaire à virgule flottante avec au moins un coefficient de correction compensant une erreur de tolérance.

9. Dispositif de conversion numérique/analogique selon la revendication 8 **caractérisé en ce que** les coefficients de correction sont stockés dans une mémoire adressable par l'exposant et/ou la mantisse du nombre binaire à virgule flottante et programmable (9, 20), de préférence une mémoire PROM (programmable Read-Only-Memory).

10. Dispositif de conversion numérique/analogique selon une des revendications 8 ou 9 **caractérisé en ce que** l'évaluateur commutable (2) se compose d'un réseau de résistances (5), ce réseau segmentant la tension de sortie du convertisseur numérique/analogique en étages de puissance de la base de l'exposant et les prises de ce réseau alimentant un multiplexeur (6), ce multiplexeur (6) étant programmable par l'exposant du nombre binaire à virgule flottante.

11. Dispositif de conversion numérique/analogique selon la revendication 10 **caractérisé en ce que** la sortie du multiplexeur (6) est reliée avec l'entrée d'un transformateur d'adaptation d'impédance, la sortie de ce transformateur étant reliée avec une pièce de fixation /17).

12. Dispositif de conversion numérique/analogique selon une des revendications 7 - 11 **caractérisé en ce qu'**une unité numérique de traitement de signaux (10) est prévue,cette unité opérant d'une part, dans la partie numérique du dispositif de conversion numérique/analogique une rectification semi- ou toute automatique des erreurs étages du circuit et comprenant, d'autre part, la première et/ou la seconde unité de calcul arithmétique (8, 21) et la mémoire (9, 20) respectivement adressable et programmable.

13. Dispositif de conversion numérique/analogique selon une des revendications 7 - 12 **caractérisé en ce que** la mémoire (9) est pilotée par l'exposant du nombre binaire à virgule flottante, cet exposant sélectionnant le premier coefficient de correction, ce coefficient étant, dans la première unité de calcul (8), combiné au moyen d'une multiplication avec la mantisse du nombre binaire à virgule flottante **et/ou en ce que** la mantisse du nombre binaire à virgule flottante sélectionne le second coefficient de correction dans la mémoire (20) respectivement adressable et programmable, ce coefficient pouvant être amené à la mantisse du nombre binaire à virgule flottante au moyen d'une addition dans la seconde unité de calcul (21).

14. Dispositif de conversion numérique/analogique selon la revendication 13 **caractérisé en ce que** la seconde unité de calcul arithmétique (21) est placée sur le chemin du signal vers le convertisseur numérique/analogique en amont ou en aval de la première unité de calcul arithmétique (8).

EP 0 513 033 B1

Fig.1

Fig.2

Fig. 3

Fig. 4

Fig. 5

Fig.6

Fig.7